Europäisches Patentamt

European Patent Office

Office européen des brevets

(11) Publication number: **0 614 274 A1**

# EUROPEAN PATENT APPLICATION

(21) Application number: **94103208.8**

(22) Date of filing: **03.03.94**

(51) Int. Cl.5: **H03K 3/01**, H03K 3/03,
H03L 1/00, G11C 11/406

(30) Priority: **04.03.93 JP 43442/93**

(43) Date of publication of application:
**07.09.94 Bulletin 94/36**

(84) Designated Contracting States:
**DE FR GB**

(71) Applicant: **NEC CORPORATION**
**7-1, Shiba 5-chome**
**Minato-ku**
**Tokyo 108-01 (JP)**

(72) Inventor: **Kubota, Shuji, c/o NEC IC**
**Microcomp. System, Ltd.**
**403-53, Kosugimachi 1-chome,**
**Nakahara-ku**
**Kawasaki-shi, Kanagawa (JP)**

(74) Representative: **VOSSIUS & PARTNER**
**Postfach 86 07 67**
**D-81634 München (DE)**

(54) **Oscillator.**

(57) Disclosed is an oscillator having an oscillation section (9) for producing and outputting an oscillation signal. A bias generating section (1) outputs a high-potential bias voltage and a low-potential bias voltage. A current supplying section (6) receives the high-potential bias voltage and the low-potential bias voltage and supplying a drive current to the oscillation section (9). The bias generating section (1) includes a first bias generator, which has a PMOS transistor (2) and a resistor (3) and produces and outputs the high-potential bias voltage when receiving a predetermined supply voltage $V_{DD}$, and a second bias generator, which has a resistor (4) and an NMOS transistor (5) and produces and outputs the low-potential bias voltage when receiving the predetermined supply voltage $V_{DD}$. The oscillator will reduce the supply voltage dependency of the oscillation frequency.

FIG. 3

EP 0 614 274 A1

The present invention relates to an oscillator, and, more particularly, to an oscillator which is formed in a DRAM having a self-refresh function.

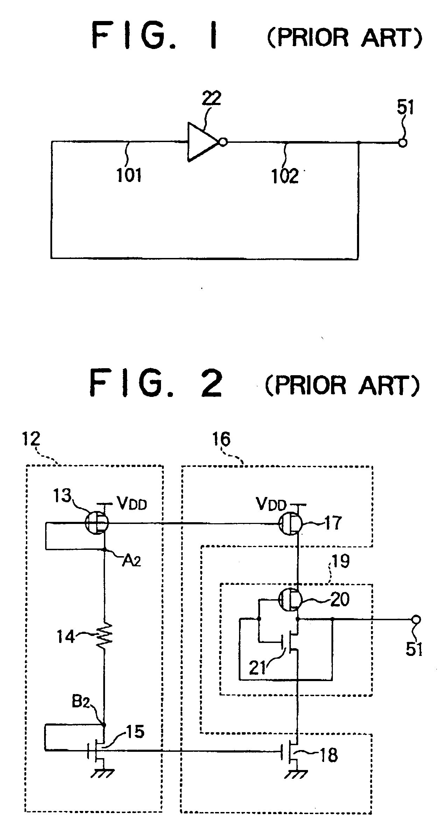

In general, an oscillator is used in a semiconductor integrated circuit to generate a periodic signal. Fig. 1 is a block diagram showing a conventional oscillator with the simplest structure. In Fig. 1, the oscillator is constituted of a CMOS inverter 22 whose output 102 is output to a terminal 51 and is fed back as an input 101 to the CMOS inverter 22.

When the potential of the input 101 is equal to the potential of the supply voltage, the potential of the output 102 changes to the ground potential and the potential of the input 101 changes to the ground potential accordingly. Then, the output 102 changes to the potential of the supply voltage. In this manner, the potential of the supply voltage and the ground potential periodically appear at the terminal 51, thus producing an oscillation signal. The oscillation frequency in this case depends on the supply voltage, the current driving power of a PMOS transistor and an NMOS transistor, which constitute the CMOS inverter 22, and a load or the like, which is connected to the output terminal 51 and is driven by the CMOS inverter 22.

Such an oscillator is also used in a DRAM. If the oscillator is used in a DRAM having a self-refresh function, the dependency of the oscillation frequency on the supply voltage should be small. The self-refresh function of a DRAM is a function, which automatically executes the periodic refresh cycle in the DRAM without any need to change a signal input to the DRAM, once the DRAM enters a self-refresh mode. To perform this operation, the oscillation output signal accomplishes a counting function so that the refresh cycle starts every time a predetermined period elapses.

Generally, as the supply voltage gets lower, the oscillation frequency of the oscillator becomes lower. Therefore, the refresh interval in self-refresh mode becomes longer as the supply voltage becomes lower. The refresh interval for the self-refresh mode should fall within a period during which a sufficient amount of charges to ensure the correct refreshing at a time of refreshing a certain memory cell again are held after this certain memory cell has been refreshed first and the other memory cells have sequentially been refreshed thereafter. This refresh interval should be set as longer as possible within that period in order to reduce the consumed current. If the supply-voltage dependency of the oscillation frequency of the oscillator is large, however, the refresh interval for the self-refresh mode should be set in such a way as to ensure refreshing when the supply voltage is low. When the supply voltage is high, on the other hand, the refresh interval becomes shorter than necessary and the consumed current increases. In this respect, the oscillator for accomplishing the self-refresh function needs to have a smaller supply-voltage dependency of the oscillation frequency.

Fig. 2 is a circuit diagram showing a conventional oscillator of this type. As shown in Fig. 2, this oscillator comprises a bias generator 12, which has a PMOS transistor 13, a resistor 14 and an NMOS transistor 15 connected between a power supply $V_{DD}$ and ground, a current supplying section 16, which includes a PMOS transistor 17 and an NMOS transistor 18, and an oscillation section 19, which includes a PMOS transistor 20 and an NMOS transistor 21.

As shown in Fig. 2, the PMOS transistor 13 has its source connected to a supply voltage $V_{DD}$ and its gate and drain connected to one end of the resistor 14. The NMOS transistor 15 has its drain and gate commonly connected to the other end of the resistor 14, with its source grounded.

The PMOS transistors 17 and 20 and NMOS transistors 21 and 18 are connected between the supply voltage $V_{DD}$ and the ground. The PMOS transistor 17 has its gate connected to the gate of the PMOS transistor 13, while the NMOS transistor 18 has its gate connected to the gate of the NMOS transistor 15. The gates and drains of the PMOS transistor 20 and NMOS transistor 21 are commonly connected to the output terminal 51.

In the bias generator 12, while a DC current flows toward the ground potential from the power supply (supply voltage $V_{DD}$), the potential at a node $A_2$, $V_{A2}$, and the potential at a node $B_2$, $V_{B2}$, are given by the following equations.

$$V_{A2} = V_{DD} + V_{TP} - \sqrt{\{(V_{DD} + V_{TP} - V_{TN})/kR)} \qquad (1)$$

$$V_{B2} = V_{TN} + \sqrt{\{(V_{DD} + V_{TP} - V_{TN})/kR)} \qquad (2)$$

where $V_{TP}$ (< 0) is the threshold value of the PMOS transistor 13, $V_{TN}$ is the threshold value of the NMOS transistor 15, R is the resistance of the resistor 14, and k is the current driving power of a MOS transistor which depends on the size of that MOS transistor, the thickness of its gate oxide film, the specific dielectric constant, and so forth. In this example, it is assumed that the PMOS transistor 13 and NMOS transistor 15 take the same value for k. The potentials $V_{A2}$ and $V_{B2}$ at the nodes $A_2$ and $B_2$ are respectively input to the gates of the PMOS transistor 17 and NMOS transistor 18 to control the drive current that is supplied to the oscillation section 19 from the current supplying section 16.

In general, the oscillation frequency of an oscillator is a reciprocal of the time from the point at which the potential of the oscillation output signal changes to the ground potential from the power supply potential to the point at which it returns to the power supply potential again. When the output potential of the oscillator changes to the ground potential from $V_{DD}$, the output potential $V_0$ of the oscillator at time t is given by the following equations.

$$V_0 = V_{DD} - (I_{DS}/C) \cdot t \qquad (3)$$

$$V_0 = \{(V_{GS} - V_{TN})/2\} \cdot \exp\{-2k(V_{GS} - V_{TN})t/C\} \qquad (4)$$

The above equation (3) is for the case where the NMOS transistor is in a saturated region and the above equation (4) is for the case where the NMOS transistor is in a non-saturated region. In these equations, $I_{DS}$ is the drain-source current of the NMOS transistor and C is the capacitance of a load which is driven by the NMOS transistor. The potential of inputs to the gates of the PMOS transistor 20 and NMOS transistor 21 lie between the power supply potential and the ground potential, and the power supply dependency of $V_{GS}$ does not differ between the oscillators shown in Figs. 1 and 2 so that the non-saturated region is negligible. But, the power supply potential dependency of the oscillation frequency of an oscillator is determined by $I_{DS}$ of the first term "$I_{DS}/C$" of time t in the equation (3) and the oscillation frequency becomes higher as $I_{DS}$ gets larger.

In the oscillator shown in Fig. 2, the discharge current of the oscillation section 19 is controlled by the NMOS transistor 18 of the current supplying section 16. The drain-source current of the NMOS transistor 18 in the saturated region, $I_{DS2}$, is expressed by the following equation.

$$I_{DS2} = k(V_{A2} - V_{TN})^2 = k_2 \cdot (V_{DD} + V_{TP} - V_{TN})/kR \qquad (5)$$

where $k_2$ is the current driving power of the NMOS transistor 18, and $V_{B2}$ is given by the equation (3). The drain-source current of the NMOS transistor 21 of the oscillation section 19 is equal to $I_{DS2}$ in the saturated region.

The drain-source current of the NMOS transistor constituting the CMOS inverter 22 in the oscillator shown in Fig. 1 in the saturated region, $I_{DS3}$, is given by the following equation.

$$I_{DS3} = k_3(V_{DD} - V_{TN})^2 \qquad (6)$$

where $K_3$ is the current driving power of the NMOS transistor which constitutes the CMOS inverter 22.

To check the supply voltage dependency of the oscillation frequency of the oscillator shown in Fig. 2, the supply voltage dependency of $I_{DS2}$ should be compared with that of $I_{DS3}$ as described above. Differentiating $I_{DS2}$ and $I_{DS3}$ with respect to the supply voltage $V_{DD}$ yields the following equations.

$$dI_{DS2}/dV_{DD} = k_2/kR \qquad (7)$$

$$dI_{DS3}/dV_{DD} = 2k_3(V_{DD} - V_{TN}) \qquad (8)$$

The supply voltage $V_{DD}$ which sets the equation (7) equal to the equation (8) is given by the following equation.

$$V_{DD} = k_2/(2kk_3R) + V_{TN} \qquad (9)$$

But, the conditions expressed by the following equations are required as the oscillation conditions for the oscillator.

$$V_{DD} > |V_{TP}| + V_{TN} \qquad (10)$$

$$k_1/(2kk_2R) < |V_{TP}| \qquad (11)$$

From the above conditions, the following inequality is always satisfied for the supply voltage on which the oscillator oscillates.

$$dI_{DS2}/dV_{DD} < dI_{DS3}/dV_{DD} \qquad (12)$$

It is therefore apparent that the supply voltage dependency of the oscillation frequency of the conventional oscillator shown in Fig. 2 is made lower than that of the oscillator, with the simplest structure shown in Fig. 1.

In the above-described conventional oscillator shown in Fig. 2, the supply voltage of the DRAM is 5 V ± 10%. In the recent trend toward the usage in portable devices or the like, however, there is a demand that DRAMs function on the supply voltage of 3 V and further have a function to hold data with 2 V. Thus, the range of the operational variation of the supply voltage becomes wider than that of the prior art, making it difficult to reduce the operation current of the oscillator in self-refresh mode. Under this circumstance, the conventional oscillator has a shortcoming that the supply voltage dependency of the oscillation frequency is too high.

It is therefore an object of the present invention to provide an oscillator which can reduce the supply voltage dependency of its oscillation frequency.

According to the present invention, there is provided an oscillator comprising: an oscillation section for producing and outputting an oscillation signal; a bias generating, section for outputting a high-potential bias voltage and a low-potential bias voltage, said bias generating section including a first bias generator for producing and outputting said high-potential bias voltage when receiving a predetermined supply voltage and a second bias generator for producing and outputting said low-potential bias voltage when receiving said predetermined supply voltage; and a current supplying section for receiving said high-potential bias voltage and said low-potential bias voltage and supplying a drive current to said oscillation section.

According to this invention, power supply potentials are separately supplied to a high-potential bias generator and a low-potential bias generator, which are both included in a bias generating section, ensuring the following advantages over the conventional oscillator.

(1) The supply voltage dependency of the oscillation frequency is reduced.

(2) The lower the supply voltage is, the smaller the supply voltage dependency of the drain-source current of an NMOS transistor included in a current supplying section becomes. As the supply voltage supplied decreases, the supply voltage dependency of the oscillation frequency gets lower.

(3) In accordance with the advantages (1) and (2), when this oscillator is adapted for a DRAM, which has a self-refresh mode and should operate on a low voltage, the supply voltage dependency of the refresh intervals in self-refresh mode will become lower than that of the conventional oscillator, thus reducing the consumed current in self-refresh mode.

Fig. 1 is a block diagram showing prior art;

Fig. 2 is a circuit diagram showing another prior art; and

Fig. 3 is a circuit diagram showing one embodiment of the present invention.

A preferred embodiment of the present invention will now be described referring to the accompanying drawings.

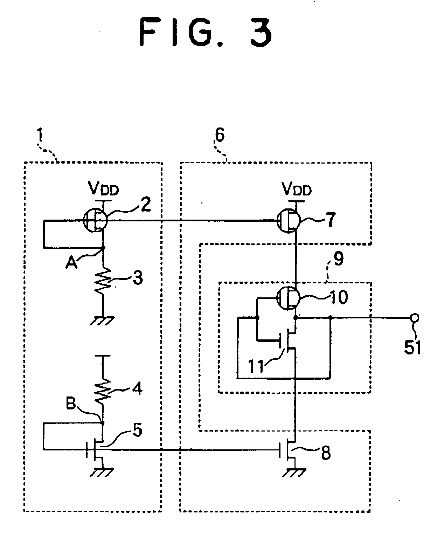

Fig. 3 presents a block diagram of an oscillator according to one embodiment of this invention. As shown in Fig. 3, the oscillator of this embodiment comprises a bias generating section 1, which includes a PMOS transistor 2, resistors 3 and 4 and an NMOS transistor 5, a current supplying section 6, which includes a PMOS transistor 7 and an NMOS transistor 8, and an oscillation section 9, which includes a PMOS transistor 10 and an NMOS transistor 11.

The PMOS transistor 2 has its source connected to a power supply $V_{DD}$, with its gate and drain commonly connected to one end of the resistor 3 at a node $A_1$. The other end of the resistor 3 is grounded. The NMOS transistor 5 has its source grounded and its gate and drain connected to a node $B_1$, with the resistor 4 connected between this node $B_1$ and the power supply $V_{DD}$.

The PMOS transistor 7 has its source connected to the power supply $V_{DD}$, its drain connected to the source of the PMOS transistor 10, and its gate connected to the gate of the PMOS transistor 2. The drain of the PMOS transistor 10 is connected to the drain of the NMOS transistor 11 and is also connected to an output terminal 51. The gates of the transistors 10 and 11 are also connected together to the output terminal 51. The NMOS transistor 8 has its source grounded, its drain connected to the source of the NMOS transistor 11 and its gate connected to the gate of the NMOS transistor 5.

As is apparent from the comparison between Fig. 3 with Fig. 2, this embodiment differs from the prior art in Fig. 2 in the internal structure of the bias circuit 1. More specifically, separate supply voltages are supplied to the PMOS transistor 2 and the NMOS transistor 5. The structure of the other components, namely the current supplying section 6 and oscillation section 9, is the same as that of the prior art.

In the bias generating section 1 of this embodiment, as shown in Fig. 3, while a DC current flows toward the ground potential from the power supply (supply voltage $V_{DD}$) for each of the PMOS transistor 2 and NMOS transistor 5, the potential at the node $A_1$, $V_{A1}$, and the potential at a node $B_1$, $V_{B1}$, are given by the following equations.

$$V_{A1} = V_{DD} + V_{TP} + (1/2kR) - (1/2kR)\sqrt{\{4kR(V_{DD} + V_{TP}) + 1\}} \qquad (13)$$

$$V_{B1} = V_{TN} - (1/2kR) + (1/2kR)\sqrt{\{4kR(V_{DD} - V_{TN}) + 1\}} \qquad (14)$$

The supply voltage dependency of the oscillation frequency in the oscillation section 9 can be checked by checking the supply voltage dependency of the drain-source current of the NMOS transistor 8 in the current supplying section 6 in the saturated region, as described earlier in the section of the prior art. The drain-source current of the NMOS transistor 8 in the saturated region, $I_{DS1}$, is given by the following equation.

$$\begin{aligned}
I_{DS1} &= k_2(V_{B1} - V_{TN})^2 \\
&= (k_2/4k^2R^2)(\sqrt{\{4kR(V_{DD} - V_{TN}) + 1\}} - 1)^2 \qquad \dots (15)
\end{aligned}$$

Differentiating both sides of the equation (15) with respect to $V_{DD}$ yields

$$dI_{DS1}/dV_{DD} = (k_2/kR)(1 - 1/\sqrt{\{4kR(V_{DD} - V_{TN}) + 1\}}) \qquad (16)$$

Comparing the equation (7) with the equation (16) yields

$$dI_{DS1}/dV_{DD} < dI_{DS2}/dV_{DD} \qquad (17)$$

It is therefore apparent from the equation (17) that the supply voltage dependency of the oscillation frequency of the oscillator according to the present embodiment shown in Fig. 3 is smaller or improved as compared with that of the conventional oscillator shown in Fig. 2.

The oscillation section of the illustrated embodiment may have a plurality of PMOS transistors and NMOS transistors connected in series, or may have an odd number of PMOS transistors and NMOS transistors, each having an inverter structure, connected in a ring shape.

**Claims**

1. An oscillator comprising:
   an oscillation section (9) for producing and outputting an oscillation signal;
   a bias generating section (1) for outputting a high-potential bias voltage and a low-potential bias voltage; and
   a current supplying section (6) for receiving said high-potential bias voltage and said low-potential bias voltage and supplying a drive current to said oscillation section;
   characterized in that,
   said bias generating section (1) includes a first bias generator (2,3) for producing and outputting said high-potential bias voltage when receiving a predetermined supply voltage and a second bias generator (4,5) for producing and outputting said low-potential bias voltage when receiving said predetermined supply voltage.

2. The oscillator according to claim 1, characterized in that,
   said first bias generator includes:
   a high-potential bias voltage output terminal,
   a PMOS transistor (2) having a source connected to a power supply (VDD) and a gate and a drain commonly connected to said high-potential bias voltage output terminal, and
   a resistor (3) having one end connected to said drain of said PMOS transistor and an other end connected to a ground potential; and
   said second bias generator includes:
   a low-potential bias voltage output terminal,
   a resistor (4) having one end connected to said supply voltage and an other end connected to said low-potential bias voltage output terminal, and

an NMOS transistor (5) having a drain and a gate commonly connected to said low-potential bias voltage output terminal and a source connected to said ground potential.

# FIG. 1 (PRIOR ART)

# FIG. 2 (PRIOR ART)

# FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | PATENT ABSTRACTS OF JAPAN vol. 9, no. 325 (E-368) (2048) 20 December 1985 & JP-A-60 158 717 (SEIKO DENSHI KOGYO K.K.) * abstract * | 1,2 | H03K3/01 H03K3/03 H03L1/00 G11C11/406 |
| X | EP-A-0 254 212 (KABUSHIKI KAISHA TOSHIBA) * column 1, line 1 - column 1, line 12 * * column 7, line 48 - column 8, line 39; figure 9 * * column 6, line 26 - column 6, line 43; figure 5 * | 1,2 | |
| P,X | US-A-5 250 914 (I. KONDO) * column 3, line 1 - column 5, line 9; figure 6 * | 1,2 | |

TECHNICAL FIELDS SEARCHED     (Int.Cl.5)

H03L
H03K

The present search report has been drawn up for all claims

| Place of search | Date of completion of the search | Examiner |
|---|---|---|
| THE HAGUE | 14 June 1994 | Dhondt, I |

EPO FORM 1503 03.82 (P04C01)